# FASCICULE DE BREVET EUROPEEN

(11) **EP 3 035 069 B1**
(45) Date de publication et mention de la délivrance du brevet: **01.11.2023**
(21) Numéro de dépôt: 15199923.2
(22) Date de dépôt: 14.12.2015
(51) Int. Cl.: G01R 31/42, H02H 3/20, H02H 3/24, H02H 3/26, H02H 3/46, H02H 7/125

(54) **TRAQUEUR POUR MACHINE ELECTRIQUE**
TRACKER FÜR ELEKTROMASCHINE
TRACKER FOR ELECTRIC MACHINE

(30) Priorité: 16.12.2014 FR 1462539
(43) Date de publication de la demande: 22.06.2016
(73) Titulaire: Schneider Electric Industries SAS, 92500 Rueil-Malmaison (FR)
(72) Inventeur: PERRIN, Alain, 38050 Grenoble Cedex 9 (FR); LEPRETTRE, Benoit, 38050 Grenoble Cedex 9 (FR); CONRATH, Christian, 38050 Grenoble Cedex 9 (FR)
(74) Mandataire: Brevalex

(56) Documents cités:
- US-A1- 2011 182 398
- US-A1- 2011 238 338
- US-A1- 2013 264 986

## Description

### DOMAINE TECHNIQUE

La présente invention concerne de manière générale un traqueur pour machine électrique. Elle concerne plus particulièrement un traqueur pour surveiller les phénomènes électriques transitoires qui peuvent exister dans une installation électrique.

### ÉTAT DE LA TECHNIQUE ANTÉRIEURE

Le fonctionnement d'une machine électrique, son entretien, sa maintenance, sa durée de vie sont conditionnés par les caractéristiques de l'alimentation électrique appliquée à la machine.

Des perturbations électriques peuvent survenir, en provenance du réseau d'alimentation, d'autres machines ou de l'installation électrique du lieu d'implantation de la machine électrique.

Les perturbations de puissance peuvent être traitées par des filtres qui ajustent l'impédance. Cependant ces filtres augmentent le coût et le volume de la machine.

En outre, toutes les perturbations n'ont pas forcément été prises en compte lors de la conception ou de l'installation de la machine. En effet, l'environnement électrique de la machine peut évoluer au cours du temps.

Dans le cas d'un dispositif électronique de puissance comportant en entrée un redresseur et un filtrage capacitif, un affaissement de tension sur l'installation électrique peut endommager le dispositif, soit en le détruisant ou en en réduisant la durée de vie.

En effet, en cas d'affaissement de tension sur au moins une phase, si le dispositif électronique est chargé, la tension sur le bus continu peut suivre la chute. La durée de la perturbation est très faible, la durée de l'affaissement de tension n'atteint pas un seuil, typiquement de 15 ms, utilisé dans les procédures de sécurité pour arrêter
correctement le dispositif. Lorsque la tension ré-augmente rapidement, un courant transitoire élevé peut exister dans le redresseur.

Pour un redresseur double alternance triphasé, comportant un couple de diodes par phase, si le courant sur une phase atteint la valeur de courant IFSM (courant temporaire de surcharge ou courant impulsionnel non répétitif) des diodes, le couple de diodes impacté peut être détruit. Si le courant sur une phase atteint la valeur de courant IFRM (courant direct moyen maximal) mais reste inférieur à la valeur de courant IFSM, le couple de diodes impacté peut être endommagé et sa durée de vie réduite.

Ainsi, il existe un besoin de suivre les phénomènes transitoires pour déterminer si la machine électrique subit ou non des perturbations susceptibles d'en affecter le fonctionnement.

US 2013/264986) divulgue un convertisseur 10 équipé d'une unité de contrôle de tension d'alimentation. La tension de chaque phase est mesurée (étape S103, paragraphe 54) et un éventuel défaut sur ces tension est recherché (étape S104). Ce dispositif ne permet pas de détecter des phénomènes transitoires de faible durée et survenant de manière irrégulière.

### EXPOSÉ DE L'INVENTION

L'invention vise à résoudre les problèmes de la technique antérieure en fournissant un traqueur pour machine électrique, tel que présenté dans le jeu de revendications.

Grâce à l'invention, des phénomènes transitoires y compris de faible durée et survenant de manière irrégulière peuvent être détectés et identifiés.

L'invention permet de définir un niveau de dangerosité, qui écarte les transitoires électriques qui n'atteignent pas ce niveau et qui distingue ceux qui l'atteigne ou le dépasse.

L'invention concerne aussi un procédé traqueur pour machine électrique, tel que défini dans le jeu de revendications.

Le procédé présente des avantages analogues à ceux précédemment présentés.

Dans un mode particulier de réalisation, les étapes du procédé selon l'invention sont mises en oeuvre par des instructions de programme d'ordinateur.

En conséquence, l'invention vise aussi un programme d'ordinateur sur un support d'informations, ce programme étant susceptible d'être mis en oeuvre dans un ordinateur, ce programme comportant des instructions adaptées à la mise en oeuvre des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions de programme d'ordinateur adaptées à la mise en oeuvre des étapes d'un procédé tel que décrit ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

### BRÈVE DESCRIPTION DES DESSINS

D'autres caractéristiques et avantages apparaîtront à la lecture de la description suivante d'un mode de réalisation préféré donné à titre d'exemple non limitatif, décrit en référence aux figures dans lesquelles :
La figure 1 représente un mode de réalisation de traqueur pour machine électrique, selon la présente invention,
La figure 2 représente un signal de différence de tension déterminé selon la présente invention,
La figure 3 représente un mode de réalisation de traqueur pour machine électrique, selon la présente invention,
La figure 4 représente un mode de réalisation de procédé mis en oeuvre dans le traqueur pour machine électrique, selon la présente invention,
La figure 5 représente un redresseur double alternance triphasé.

### EXPOSÉ DÉTAILLÉ DE MODES DE RÉALISATION PARTICULIERS

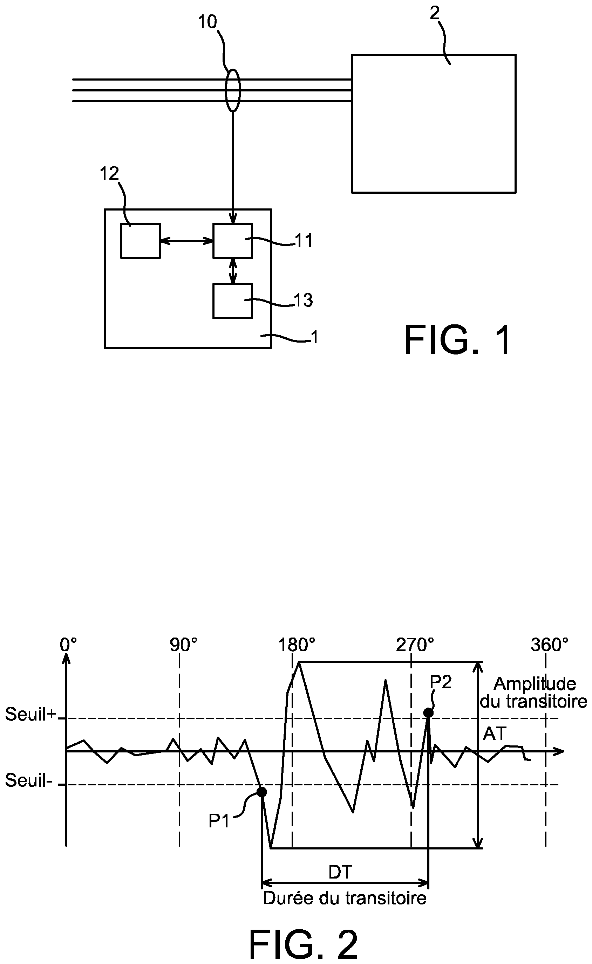

Selon un mode de réalisation préféré représenté à la **figure 1**, un traqueur 1 pour machine électrique équipe une machine électrique triphasée 2. Le traqueur comporte des capteurs de mesure de paramètres d'environnement, de courant et de tension.

Les capteurs d'environnement mesurent des grandeurs telles que la température, l'humidité, la poussière, la corrosivité ou encore la luminosité.

On s'intéresse plus particulièrement aux capteurs de tension 10 qui effectuent des mesures de la tension d'alimentation appliquée sur chaque phase.

Le traqueur comporte également un détecteur de transitoire électrique 11. Ce détecteur reçoit les valeurs de tension mesurées et les traite pour détecter un éventuel phénomène transitoire. On appelle transitoire électrique une perturbation, généralement à haute fréquence, qui affecte l'alimentation électrique de la machine électrique.

Le détecteur de transitoire électrique 11 effectue les opérations suivantes, qui comportent principalement la détection, la caractérisation et la validation de transitoires électriques.

Le détecteur 11 acquiert des échantillons de mesures de tension. Pour une tension alternative, les échantillons sont acquis pendant au moins deux cycles successifs de tension. De préférence, les échantillons sont acquis en continu.

Les échantillons de mesures acquis sont mémorisés dans une mémoire 12 reliée au détecteur.

Les différences entre les échantillons de mesures acquis pour deux cycles successifs sont calculées phase par phase. On détermine ainsi un ensemble de valeurs de différence pour deux cycles successifs. Si la tension est parfaitement régulière, les mesures se répètent à l'identique d'un cycle à l'autre, et les valeurs de différence sont nulles. Bien entendu, en pratique, un certain niveau de différence entre deux cycles peut exister en raison d'un « bruit » inhérent au milieu dans lequel la machine électrique est installée.

La **figure 2** représente un signal de valeurs de différence sur un cycle, en fonction du temps. Comme on le verra dans la suite, ce signal laisse apparaître un transitoire électrique.

Les valeurs de différences calculées sont comparées avec un seuil prédéterminé qui tient compte du bruit. Le seuil est choisi en fonction des différences de tension qui sont tolérées d'un cycle à l'autre. Les différences de tension tolérées sont en général faibles. Il est possible de choisir un seuil positif et un seuil négatif différents l'un de l'autre. Les seuils positif et négatif sont représentés par des lignes en pointillé à la figure 2.

Si pour un cycle donné d'une phase donnée, aucune valeur de différence calculée par rapport au cycle précédent n'est supérieure au seuil prédéterminé, alors il n'y a pas de transitoire électrique.

Au contraire, si pour un cycle donné d'une phase donnée, il existe au moins une valeur de différence calculée par rapport au cycle précédent qui est supérieure au seuil prédéterminé, alors il y a un transitoire électrique. Ainsi, on voit dans l'exemple de la figure 2 que le signal de différence franchit une première fois le seuil en un point P1, puis le franchit plusieurs fois jusqu'à un point P2 à partir duquel le signal de différence reste inférieur au seuil, sur le cycle considéré.

Les opérations de calculs de valeurs de différence et de comparaison avec le seuil prédéterminé sont répétées pour tous les cycles de tension et pour toutes les phases.

En variante, la détection de transitoire électrique est fondée sur un filtrage passe-haut des échantillons de mesure de tension.

Dans ce cas, le détecteur acquiert des échantillons de mesures de tension. De préférence, les échantillons sont acquis en continu.

Il est à noter qu'il n'est pas nécessaire de mémoriser les échantillons de mesures acquis.

Les échantillons acquis sont ensuite filtrés par un filtre passe-haut, par exemple un filtre d'ordre 2. La fréquence de coupure du filtre passe-haut est choisie pour être légèrement inférieure aux fréquences typiquement comprises dans les transitoires électriques.

Les valeurs des échantillons filtrés sont comparées avec un seuil.

Si aucune valeur d'échantillon filtré n'est supérieure au seuil, alors il n'y a pas de transitoire électrique.

Inversement, si une valeur d'échantillon filtré est supérieure au seuil, alors il y a un transitoire électrique.

Selon une autre variante, la détection de transitoire électrique est fondée sur une analyse de type ondelettes des échantillons de mesure de tension.

Comme pour la variante précédente, le détecteur acquiert des échantillons de mesures de tension. De préférence, les échantillons sont acquis en continu. Il est à noter là aussi qu'il n'est pas nécessaire de mémoriser les échantillons de mesures acquis sur plusieurs cycles.

Les échantillons acquis sont ensuite comparés à une ou plusieurs ondelette(s) de référence au moyen d'une Transformée en Ondelettes ou d'une Transformée de Fourier, qui produit un ou plusieurs coefficients. Une ondelette de référence est formée d'un ou de plusieurs morceau(x) de sinusoïde ou de préférence forme(s) d'onde plus transitoire(s).

Les valeurs du ou des coefficient(s) est (sont) comparée(s) avec un seuil.

Si aucun coefficient n'est supérieur en valeur absolue au seuil, alors il n'y a pas de transitoire électrique.

Inversement, si un ou plusieurs coefficient(s) est (sont) supérieur(s) au seuil, alors il y a un transitoire électrique.

Dans tous les cas, lorsqu'un transitoire électrique est détecté, il est caractérisé. Ainsi, le transitoire représenté à la figure 2 a un instant de début repéré par le point P1 et un instant de fin repéré par le point P2. La durée du transitoire DT est donc connue.

Si le signal de différence est synchronisé sur le passage par zéro de la tension, il est possible de déterminer la position du transitoire électrique dans le cycle. Dans l'exemple représenté, le transitoire électrique commence avant 180° (soit une demi période) et se termine après 270° (soit trois quarts de période).

L'amplitude du transitoire AT est déterminée par exemple par la différence entre le maximum et le minimum du signal. Elle peut aussi être déterminée à partir de l'écart-type, ou par la valeur numérique du ou des coefficient(s) obtenu(s) si une détection à base de Transformée en Ondelettes est utilisée.

Bien entendu, d'autres mesures peuvent être effectuées pour caractériser le transitoire électrique. Par exemple, afin de caractériser les fréquences qu'il contient, il est possible de compter le nombre de passages par zéro au cours du transitoire. Si le transitoire électrique comporte une fréquence dominante, alors elle est proportionnelle au nombre de passage par zéro du signal de différence, ramené à la durée du transitoire.

Il est aussi possible d'effectuer un filtrage passe-bande sur une bande spectrale d'intérêt. Il est encore possible d'appliquer une transformée de Fourier pour passer dans le domaine fréquentiel et effectuer un seuillage. On détermine alors le contenu fréquentiel du transitoire électrique. Cette détermination est effectuée en plus de celles de l'amplitude et de la position.

Lorsque la détection repose sur une transformée en ondelettes ou de Fourier, la position du ou des coefficients d'amplitude dominante permet de déterminer directement la ou les plage(s) fréquentielle(s) de transitoire électrique.

En fonction des résultats de la caractérisation, un transitoire électrique est validé ou non.

Plusieurs critères de validation peuvent être utilisés, considérés isolément ou en combinaison. Par exemple, un transitoire électrique est validé si son amplitude dépasse un seuil d'amplitude. Le seuil d'amplitude est déterminé en fonction de la dangerosité associée à l'amplitude.

Un autre critère de validation est la position angulaire du transitoire. Les transitoires sont plus dangereux pour la machine électrique lorsque la tension est maximale, soit à 90° et 270°, en supposant toujours que le cycle commence lorsque la tension est nulle. On peut donc définir des zones autour des maxima de tension, par exemple de 45° à 135° et de 225° à 315°. Un transitoire électrique est validé s'il se trouve au moins en partie dans une de ces zones.

Lorsque le contenu fréquentiel du transitoire électrique a été déterminé, un critère de validation peut être une comparaison de ce contenu fréquentiel avec un ou plusieurs seuil(s) de fréquence. En effet, la dangerosité d'un transitoire électrique pour les équipements électriques, notamment les diodes, peut être liée aux fréquences de ce transitoire électrique.

Ainsi la validation a pour résultat d'identifier les transitoires électriques potentiellement dangereux pour la machine électrique car ils peuvent en affecter le fonctionnement ou réduire sa durée de vie.

Lorsqu'un transitoire électrique répond aux critères de validation, le détecteur 11 envoie cette information et/ou une alerte vers une interface homme-machine 13 destinée à fournir des informations à un opérateur.

Le traqueur 1 est installé dans la machine électrique 2 ou en variante il est indépendant de celle-ci. Selon une autre variante, seuls les capteurs 10 sont situés au niveau de la machine électrique. Les capteurs 10 transmettent les résultats de mesure à une unité distante qui réalise les traitements sur les mesures.

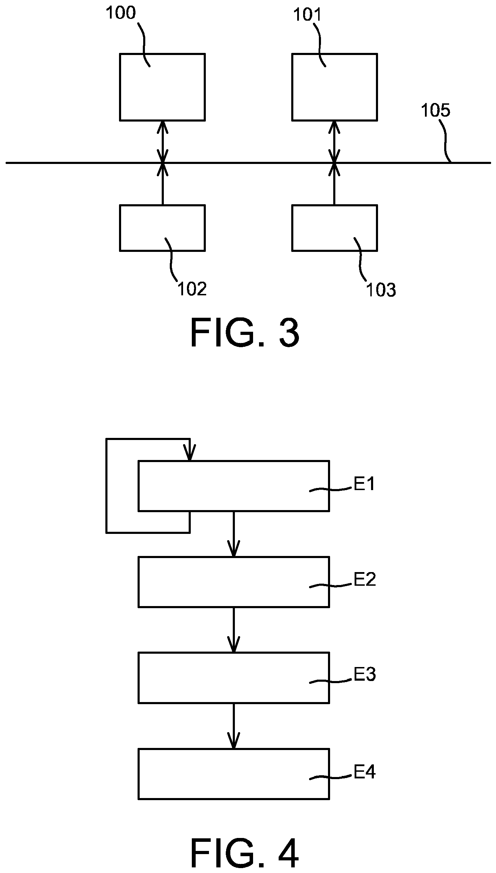

La **figure 3** représente un mode de réalisation particulier de traqueur pour machine électrique, selon l'invention.

Le traqueur a la structure générale d'un ordinateur. Il comporte notamment un processeur 100 exécutant un programme d'ordinateur mettant en oeuvre le procédé selon l'invention qui va être décrit dans la suite, une mémoire 101, une interface d'entrée 102 et une interface de sortie 103.

Ces différents éléments sont classiquement reliés par un bus 105.

L'interface d'entrée 102 est principalement un ensemble de capteurs de tension qui effectuent des mesures des tensions d'alimentation appliquées sur chaque phase. L'interface 102 produit des données représentant les mesures de tension.

Le processeur 100 exécute les traitements exposés dans la suite. Ces traitements sont réalisés sous la forme d'instructions de code du programme d'ordinateur qui sont mémorisées par la mémoire 101 avant d'être exécutées par le processeur 100.

La mémoire 101 mémorise également données de mesure ainsi que les résultats des traitements effectués.

L'interface de sortie 103 est une interface homme-machine 104 destinée à fournir des informations à un opérateur sur les transitoires électriques qui ont été validés, c'est-à-dire identifiés comme potentiellement dangereux. L'interface homme-machine peut aussi servir à l'opérateur pour introduire des paramètres de réglages, par exemple les seuils ou encore pour sélectionner les paramètres de caractérisation ou les critères de validation de transitoires électriques.

Les traitements sur les mesures peuvent être effectués soit localement, soit à distance, par exemple sur un serveur.

Selon un mode de réalisation préféré représenté à la **figure 4**, le procédé mis en oeuvre dans le traqueur pour machine électrique comporte des étapes E1 à E4.

L'étape E1 est la mesure de la tension d'alimentation appliquée sur chaque phase. Des échantillons de mesures de tension sont acquis pendant au moins deux cycles successifs de tension. De préférence, les échantillons sont acquis en continu, c'est-à-dire que l'étape E1 est réitérée en boucle.

Les échantillons de mesures acquis sont mémorisés dans une mémoire.

L'étape suivante E2 est une détection de transitoire électrique en fonction des résultats de mesures.

Pour cela, les différences entre les échantillons de mesures acquis pour deux cycles successifs sont calculées phase par phase. On détermine ainsi un ensemble de valeurs de différence pour deux cycles successifs.

Les valeurs de différences calculées sont comparées avec un seuil prédéterminé. Le seuil est choisi en fonction des différences de tension qui sont tolérées d'un cycle à l'autre. Les différences de tension tolérées sont en général faibles. Il est possible de choisir un seuil positif et un seuil négatif différents l'un de l'autre.

Si pour un cycle donné d'une phase donnée, aucune valeur de différence calculée par rapport au cycle précédent n'est supérieure au seuil prédéterminé, alors il n'y a pas de transitoire électrique.

Au contraire, si pour un cycle donné d'une phase donnée, il existe au moins une valeur de différence calculée par rapport au cycle précédent qui est supérieure au seuil prédéterminé, alors il y a un transitoire électrique. Ainsi, on voit dans l'exemple de la figure 2 que le signal de différence franchit une première fois le seuil en un point P1, puis le franchit plusieurs fois jusqu'à un point P2 à partir duquel le signal de différence reste inférieur au seuil, sur le cycle considéré.

Les opérations de calculs de valeurs de différence et de comparaison avec le seuil prédéterminé sont répétées pour tous les cycles de tension et pour toutes les phases.

Bien entendu, la détection de transitoire électrique peut être effectuée selon l'une des variantes exposées plus haut.

Lorsqu'il y a une détection de transitoire électrique, l'étape E2 est suivie de l'étape E3 qui est une caractérisation du transitoire électrique détecté. La caractérisation comporte la détermination d'un ensemble de paramètres du transitoire électrique. Ces paramètres sont choisis en fonction de l'appréciation du risque encouru par la machine électrique en raison de transitoires électriques.

L'ensemble de ces paramètres peut comprendre la durée du transitoire électrique, sa position dans le cycle, son amplitude, le nombre de passages par zéro du signal de différence au cours du transitoire.

Il est aussi possible d'effectuer un filtrage passe-bande sur une bande spectrale d'intérêt. Il est encore possible d'appliquer une transformée de Fourier pour travailler dans le domaine fréquentiel et effectuer un seuillage.

L'étape suivante E4 est un test de validation du transitoire électrique, en fonction des résultats de la caractérisation qui sont comparés à des seuils.

Plusieurs critères de validation peuvent être utilisés, considérés isolément ou en combinaison. Par exemple, un transitoire électrique est validé si son amplitude dépasse un seuil d'amplitude. Le seuil d'amplitude est déterminé en fonction de la dangerosité associée à l'amplitude.

Un autre critère de validation est la position angulaire du transitoire. Les transitoires sont plus dangereux pour la machine électrique lorsque la tension est maximale, soit à 90° et 270°, en supposant toujours que le cycle commence lorsque la tension est nulle. On peut donc définir des zones autour des maxima de tension, par exemple de 45° à 135° et de 225° à 315°. Un transitoire électrique est validé s'il se trouve au moins en partie dans une de ces zones.

Lorsqu'un transitoire électrique est validé, c'est-à-dire identifié comme potentiellement dangereux, des informations sont fournies à un opérateur.

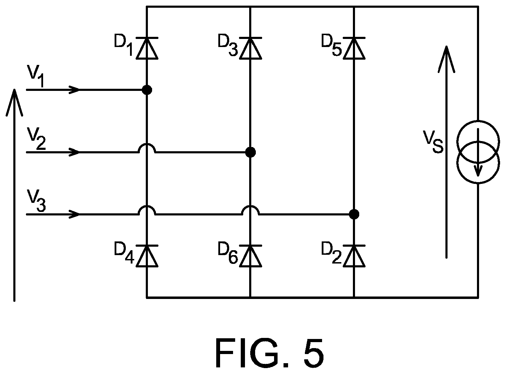

En référence à la **figure 5**, un redresseur double alternance triphasé a une structure classique en pont de Graëtz.

A l'entrée du pont, les tensions V₁, V₂ et V₃ sont des tensions sinusoïdales entre phase et neutre.

Le pont comporte six diodes D₁ à D₆. En sortie du pont, la tension de sortie est notée Vₛ.

A un instant donné, un couple de diode est conducteur. Le couple de diode qui est conducteur change au cours du cycle de tension.

Parmi les diodes D₁, D₃ et D₅, celle qui a la tension sur son anode la plus positive conduit.

Parmi les diodes D₂, D₄ et D₆, celle qui a la tension sur son anode la plus positive conduit.

Ainsi par exemple :
Entre 0 et T/12, la tension V₃ est maximale et la tension V₂ est minimale. Par conséquent, les diodes D₅ et D₆ conduisent donc et la tension de sortie Vₛ vaut la tension U₃₂ entre les phases 3 et 2.
Entre T/12 et T/4, la tension V₁ est maximale et la tension V₂ est minimale. Par conséquent, les diodes D₁ et D₆ conduisent et la tension de sortie Vₛ vaut la tension U₁₂ entre les phases 1 et 2.
Entre T/4 et 5T/12, la tension V₁ est maximale et la tension V₃ est minimale. Par conséquent, les diodes D₁ et D₂ conduisent et la tension de sortie Vₛ vaut la tension U₁₃ entre les phases 1 et 3.

Il y a donc au total six couples de diodes qui conduisent successivement :
- D₁ et D₆, tension de sortie U₁₂,
- D₁ et D₂, tension de sortie U₁₃,
- D₃ et D₂, tension de sortie U₂₃,
- D₃ et D₄, tension de sortie U₂₁,
- D₅ et D₄, tension de sortie U3₁,
- D₅ et D₆, tension de sortie U₃₂.

Dans un cycle de tension, les changements de couple de diodes conductrices se font tous les 60°.

Ainsi, lorsqu'un transitoire est détecté, l'étape de validation peut déterminer quel est le couple de diodes potentiellement impacté, ou quels sont les couples de diodes potentiellement impactés, par ce transitoire à partir de la position du transitoire dans le cycle. En reprenant l'exemple de la figure 2, le transitoire est situé entre les points P1 et P2, qui définissent une portion du cycle commençant un peu avant 180° et se terminant un peu après 270°. Cette portion de cycle correspond à trois couples de diodes.

L'amplitude du transitoire électrique est également prise en compte car il peut impacter le couple de diodes selon la règle suivante :
Les fonctions Max et Min assurent que
- parmi les diodes D₁, D₃ et D₅, celle qui a la tension sur son anode la plus positive conduit,
- parmi les diodes D₂, D₄ et D₆, celle qui a la tension sur sa cathode la plus négative conduit.

Après avoir caractérisé le couple de diodes impacté, il est possible de cumuler et d'indiquer, selon un premier niveau de service, le nombre d'impacts pour chaque diode au fil du temps. Cela fournit à l'utilisateur une image de la qualité du réseau électrique et les incidences possibles sur les équipements d'électronique de puissance.

Selon un niveau de service renforcé, il est en outre possible de caractériser le niveau de sévérité du transitoire rapide. Pour ce faire il faut connaître la caractéristique de la capacité de filtrage, l'amplitude et la durée de remontée du transitoire rapide.

En effet, dans le cas d'un dispositif électronique de puissance comportant en entrée un redresseur et un filtrage capacitif, un affaissement de tension sur l'installation électrique peut endommager le dispositif, soit en le détruisant ou en en réduisant la durée de vie.

En cas d'affaissement de tension sur au moins une phase, si le dispositif électronique est chargé, la tension sur le bus continu peut suivre la chute. La durée de la perturbation est très faible, la durée de l'affaissement de tension n'atteint pas un seuil, typiquement de 15 ms, utilisé dans les procédures de sécurité pour arrêter correctement le dispositif. Lorsque la tension ré-augmente rapidement, un courant transitoire élevé peut exister dans le redresseur.

Pour un redresseur double alternance triphasé, comportant un couple de diodes par phase, tel que représenté à la figure 5, si le courant sur une phase atteint la valeur de courant IFSM (courant temporaire de surcharge ou courant impulsionnel non répétitif) des diodes, le couple de diodes impacté peut être détruit. Si le courant sur une phase atteint la valeur de courant IFRM (courant direct moyen maximal) mais reste inférieur à la valeur de courant IFSM, le couple de diodes impacté peut être endommagé et sa durée de vie réduite.

Il est donc possible d'indiquer le nombre d'occurrence d'impact pour les différentes diodes avec la sévérité potentiel de l'impact : courant destructif ou faisant vieillir.

Il est en outre possible de déterminer si la capacité de filtrage était alors en limite de charge, pour distinguer des impacts potentiels et réels. En effet si l'équipement n'est pas chargé (ne débite pas sur une charge) la tension aux bornes de la capacité n'évolue pas et l'impact est nul.

De plus, les équipements sont conçus avec un surdimensionnement. Pour que la situation soit réellement dangereuse, il faut donc que ces conditions sur les transitoires soit liées à un creux de tension lent (sur plusieurs alternances) pour faire en sorte que la tension aux bornes de la capacité de filtrage épouse effectivement le creux de tension du transitoire rapide et que le courant traversant les diodes lors de la remonté rapide implique l'impact détecté avant.

Le signal peut être filtré pour tenir compte des niveaux de réjection natifs des équipements électroniques de puissance. Par exemple, on détecte les creux de tension de largeur supérieure à 4 ms et d'amplitude 30% inférieure à la moyenne des amplitudes des dix ou vingt périodes précédentes. On rappelle que les creux de tension de plus de 15 ms sont classiquement traités par les procédures de sécurité.

Avantageusement, il est encore possible de déterminer des informations sur les charges perturbatrices en analysant les phases perturbées par les transitoires électriques. Si trois phases sont impactées alors la source perturbatrice est triphasée, si seulement deux phases sont impactées, alors la source perturbatrice était connectée sur ces deux phases, et si une seule phase est impactée alors la charge perturbatrice est monophasée. Cela facilite la détermination et l'identification de la source de la perturbation.

En outre, l'analyse de la forme d'onde du courant sur la ligne en amont de l'équipement peut être utilisée pour déterminer l'origine de la source de perturbation: interne à l'installation électrique ou provenant du réseau.

En effet, on considère que la capacité du générateur provenant du réseau de fourniture est grande devant la puissance de l'installation. Si la baisse de tension est accompagnée d'une baisse de courant, c'est que le générateur s'écroule et donc que l'origine de la perturbation vient probablement du réseau. En revanche, si le courant augmente lors de la baisse de tension, c'est que le générateur assure sa capacité tampon et que la source de perturbation est probablement sur l'installation électrique du site.

## Revendications

1. Traqueur pour machine électrique alimentée par une tension d'alimentation alternative sur au moins une phase, comportant :
- Des moyens (10) de mesure de tension alternative d'alimentation, **caractérisé en ce qu'**il comporte
- Des moyens (11) de détection de transitoire électrique en fonction des mesures effectuées, les moyens (11) de détection de transitoire électrique étant adaptés pour :
- Acquérir des échantillons de mesures de tension pendant au moins deux cycles de tension successifs,
- Mémoriser les échantillons de mesures acquis,
- Calculer les différences de tension entre les échantillons de mesures acquis pour les au moins deux cycles successifs,
- Comparer les différences calculées avec un seuil prédéterminé,
- Détecter un transitoire électrique si une différence est supérieure au seuil prédéterminé,
- Des moyens (11) de caractérisation de transitoire électrique détecté, pour déterminer un ensemble de paramètres du transitoire électrique, comportant au moins un paramètre choisi parmi l'amplitude du transitoire électrique et la position du transitoire électrique dans le cycle de tension,
- Des moyens (11) de validation de transitoire électrique mettant en oeuvre au moins un critère de validation choisi parmi la validation d'un transitoire électrique si son amplitude dépasse un seuil d'amplitude et la validation d'un transitoire électrique si la position du transitoire électrique se trouve au moins en partie dans une de zones définies autour des maxima de tension, afin d'identifier si un transitoire électrique affecte la machine électrique.

2. Traqueur pour machine électrique selon la revendication 1, **caractérisé en ce que** les moyens (11) de caractérisation de transitoire détecté sont en outre adaptés pour
- Déterminer le contenu fréquentiel du transitoire électrique.

3. Traqueur pour machine électrique selon la revendication 2, **caractérisé en ce que** les moyens (11) de validation de transitoire électrique sont adaptés pour comparer le contenu fréquentiel avec au moins un seuil de fréquence.

4. Traqueur pour machine électrique selon l'une quelconque des revendications 1 à 3, lorsque la machine électrique a une structure de redresseur double alternance triphasé en pont de Graëtz, **caractérisé en ce que** les moyens (11) de validation sont adaptés pour déterminer au moins un couple de diodes du pont de Graëtz impacté par le transitoire électrique.

5. Traqueur pour machine électrique selon la revendication 4, **caractérisé en ce que** les moyens (11) de validation de transitoire électrique sont adaptés pour cumuler le nombre d'impacts pour chaque diode au fil du temps.

6. Procédé traqueur pour machine électrique alimentée par une tension d'alimentation alternative sur au moins une phase, comportant une étape de :
- mesure (E1) de tension alternative d'alimentation,
**caractérisé en ce qu'**il comporte des étapes de :
- détection (E2) de transitoire électrique en fonction des mesures effectuées, la détection de transitoire électrique comportant
- l'acquisition d'échantillons de mesures de tension pendant au moins deux cycles de tension successifs,
- la mémorisation des échantillons de mesures acquis,
- le calcul des différences de tension entre les échantillons de mesures acquis pour les au moins deux cycles successifs,
- la comparaison des différences calculées avec un seuil prédéterminé,
- la détection d'un transitoire électrique si une différence est supérieure au seuil prédéterminé,
- caractérisation (E3) de transitoire électrique détecté, pour déterminer un ensemble de paramètres du transitoire électrique, comportant au moins un paramètre choisi parmi l'amplitude du transitoire électrique et la position du transitoire électrique dans le cycle de tension,
- validation (E4) de transitoire électrique mettant en oeuvre au moins un critère de validation choisi parmi la validation d'un transitoire électrique si son amplitude dépasse un seuil d'amplitude et la validation d'un transitoire électrique si la position du transitoire électrique se trouve au moins en partie dans une de zones définies autour des maxima de tension, afin d'identifier si un transitoire électrique affecte la machine électrique.

7. Programme d'ordinateur comportant des instructions pour l'exécution des étapes du procédé selon la revendication 6 lorsque ledit programme est exécuté par un ordinateur.

8. Support d'enregistrement lisible par un ordinateur sur lequel est enregistré un programme d'ordinateur comprenant des instructions pour l'exécution des étapes du procédé selon la revendication 6.

## Patentansprüche

1. Tracker für eine elektrische Maschine, die auf mindestens einer Phase mit einer Wechselstromversorgungsspannung versorgt wird, Folgendes umfassend:
- Ein Mittel (10) zum Messen der Wechselstromversorgungsspannung,
**dadurch gekennzeichnet, dass** er Folgendes umfasst:
- Ein Mittel (11) zum Detektieren einer elektrischen Transienten in Abhängigkeit von den durchgeführten Messungen, wobei das Mittel (11) zum Detektieren einer elektrischen Transienten für Folgendes ausgelegt ist:
- Erfassen von Spannungsmessproben während mindestens zwei aufeinanderfolgenden Spannungszyklen,
- Speichern der erfassten Messproben,
- Berechnen der Spannungsdifferenzen zwischen den erfassten Messproben für die mindestens zwei aufeinanderfolgende Zyklen,
- Vergleichen der berechneten Differenzen mit einem vorgegebenen Schwellenwert,
- Detektieren einer elektrischen Transienten, wenn eine Differenz größer als der vorgegebene Schwellenwert ist,
- ein Mittel (11) zum Charakterisieren der detektierten elektrischen Transienten, um einen Satz von Parametern der elektrischen Transienten zu bestimmen, der mindestens einen Parameter umfasst, der aus der Amplitude der elektrischen Transienten und der Position der elektrischen Transienten im Spannungszyklus ausgewählt wird,
- ein Mittel (11) zum Validieren der elektrischen Transienten, das mindestens ein Validierungskriterium umsetzt, das aus der Validierung einer elektrischen Transienten, wenn ihre Amplitude einen Amplitudenschwellenwert überschreitet, und der Validierung einer elektrischen Transienten, wenn sich die Position der elektrischen Transienten zumindest teilweise in einer der um die Spannungsmaxima definierten Zonen befindet, ausgewählt wird, um festzustellen, ob eine elektrische Transiente die elektrische Maschine beeinflusst.

2. Tracker für eine elektrische Maschine nach Anspruch 1,
**dadurch gekennzeichnet, dass** das Mittel (11) zum Charakterisieren der detektierten Transienten ferner für Folgendes ausgelegt ist:
- Bestimmen des Frequenzinhalts der elektrischen Transienten.

3. Tracker für eine elektrische Maschine nach Anspruch 2, **dadurch gekennzeichnet, dass** das Mittel (11) zum Validieren der elektrischen Transienten dafür ausgelegt ist, den Frequenzinhalt mit mindestens einem Frequenzschwellenwert zu vergleichen.

4. Tracker für eine elektrische Maschine nach einem der Ansprüche 1 bis 3, wobei die elektrische Maschine eine dreiphasige Doppelgleichrichterstruktur in Form einer Graetz-Brücke aufweist, **dadurch gekennzeichnet, dass** das Mittel (11) zum Validieren dafür ausgelegt ist, mindestens ein Diodenpaar der Graetz-Brücke zu bestimmen, auf die sich die elektrische Transiente auswirkt.

5. Tracker für eine elektrische Maschine nach Anspruch 4, **dadurch gekennzeichnet, dass** das Mittel (11) zum Validieren einer elektrischen Transienten dafür ausgelegt ist, die Anzahl der Auswirkungen für jede Diode im Laufe der Zeit zu kumulieren.

6. Tracker-Verfahren für eine elektrische Maschine, die auf mindestens einer Phase mit einer Wechselstromversorgungsspannung versorgt wird, umfassend einen Schritt des:
- Messens (E1) der Wechselstromversorgungsspannung,
**dadurch gekennzeichnet, dass** es die folgenden Schritte umfasst:
- Detektieren (E2) einer elektrischen Transienten in Abhängigkeit von den durchgeführten Messungen, wobei das Detektieren einer elektrischen Transienten Folgendes umfasst
- Erfassen von Spannungsmessproben während mindestens zwei aufeinanderfolgenden Spannungszyklen,
- Speichern der erfassten Messproben,
- Berechnen der Spannungsdifferenzen zwischen den erfassten Messproben für die mindestens zwei aufeinanderfolgende Zyklen,
- Vergleichen der berechneten Differenzen mit einem vorgegebenen Schwellenwert,
- Detektieren einer elektrischen Transienten, wenn eine Differenz größer als der vorgegebene Schwellenwert ist,
- Charakterisieren (E3) der detektierten elektrischen Transienten, um einen Satz von Parametern der elektrischen Transienten zu bestimmen, der mindestens einen Parameter umfasst, der aus der Amplitude der elektrischen Transienten und der Position der elektrischen Transienten im Spannungszyklus ausgewählt wird,
- Validieren (E4) der elektrischen Transienten, das mindestens ein Validierungskriterium umsetzt, das aus der Validierung einer elektrischen Transienten, wenn ihre Amplitude einen Amplitudenschwellenwert überschreitet, und der Validierung einer elektrischen Transienten, wenn sich die Position der elektrischen Transienten zumindest teilweise in einer der um die Spannungsmaxima definierten Zonen befindet, ausgewählt wird, um festzustellen, ob eine elektrische Transiente die elektrische Maschine beeinflusst.

7. Computerprogramm, das Anweisungen zum Ausführen der Schritte des Verfahrens nach Anspruch 6 umfasst, wenn das Programm von einem Computer ausgeführt wird.

8. Computerlesbares Aufzeichnungsmedium, auf dem ein Computerprogramm aufgezeichnet ist, das Anweisungen zum Ausführen der Schritte des Verfahrens nach Anspruch 6 umfasst.

## Claims

1. A tracker for an electrical machine supplied by an alternating supply voltage on at least one phase, including:
- means (10) for measuring an alternating supply voltage,
**characterised in that** it includes
- means (11) for detecting an electrical transient as a function of the measurements performed, the means (11) for detecting an electrical transient being adapted to:
- acquire voltage measurement samples during at least two successive voltage cycles,
- store the measurement samples acquired,
- calculate the voltage differences between the measurement samples acquired for the at least two successive cycles,
- compare the differences calculated with a predetermined threshold,
- detect an electrical transient if a difference is greater than the predetermined threshold,
- means (11) for characterising the electrical transient detected, to determine a set of parameters of the electrical transient, including at least one parameter selected from the amplitude of the electrical transient and the position of the electrical transient in the voltage cycle,
- means (11) for validating the electrical transient implementing at least one validation criterion selected from the validation of an electrical transient if its amplitude exceeds an amplitude threshold and the validation of an electrical transient if the position of the electrical transient is at least partly in one of zones defined about the voltage maxima, in order to identify whether an electrical transient affects the electrical machine.

2. The tracker for an electrical machine according to claim 1,
**characterised in that** the means (11) for characterising the transient detected are further adapted to
- determine the frequency content of the electrical transient.

3. The tracker for an electrical machine according to claim 2, **characterised in that** the means (11) for validating the electrical transient are adapted to compare the frequency content with at least one frequency threshold.

4. The tracker for an electrical machine according to any of claims 1 to 3, when the electrical machine has a Graetz bridge three-phase full-wave rectifier structure, **characterised in that** the validation means (11) are adapted to determine at least one pair of diodes of the Graetz bridge impacted by the electrical transient.

5. The tracker for an electrical machine according to claim 4, **characterised in that** the means (11) for validating the electrical transient are adapted to cumulate a number of impacts for each diode over time.

6. A tracking method for an electrical machine supplied by an alternating supply voltage on at least one phase, including a step of:
- measuring (E1) an alternating supply voltage,
**characterised in that** it includes the steps of:
- detecting (E2) an electrical transient as a function of the measurements performed, detecting an electrical transient including:
- acquiring voltage measurement samples during at least two successive voltage cycles,
- storing the measurement samples acquired,
- calculating the voltage differences between the measurement samples acquired for the at least two successive cycles,
- comparing the differences calculated with a predetermined threshold,
- detecting an electrical transient if a difference is greater than the predetermined threshold,
- characterising (E3) the electrical transient detected, to determine a set of parameters of the electrical transient, including at least one parameter selected from the amplitude of the electrical transient and the position of the electrical transient in the voltage cycle,
- validating (E4) the electrical transient implementing at least one validation criterion selected from the validation of an electrical transient if its amplitude exceeds an amplitude threshold and the validation of an electrical transient if the position of the electrical transient is at least partly in one of zones defined about the voltage maxima, in order to identify whether an electrical transient affects the electrical machine.

7. A computer program including instructions for executing the steps of the method according to claim 6 when said program is executed by a computer.

8. A computer readable recording medium having a computer program recorded thereon comprising instructions for executing the steps of the method according to claim 6.
